# EUROPEAN PATENT APPLICATION

(11) **EP 4 539 124 A1**
(43) Date of publication of application: **16.04.2025**
(21) Application number: 23203231.8
(22) Date of filing: 12.10.2023
(51) Int. Cl.: H01L 27/146

(54) **PHOTO-SENSITIVE DEVICE AND IMAGE SENSOR WITH GUARD RING FOR CROSSTALK SUPPRESSION**

(71) Applicant: Imec VZW, 3001 Leuven (BE)
(72) Inventor: KIM, Joo Hyoung, 3000 Leuven (BE); GEORGITZIKIS, Epimitheas, 1060 Saint-Gilles (BE); GENOE, Jan, 3272 Testelt (BE); LEE, Jiwon, 3020 Herent (BE)
(74) Representative: AWA Sweden AB

(57) **Abstract**

According to an aspect of the present inventive concept there is provided a photo-sensitive device (100; 200; 300; 400; 500) comprising: a stack (102; 202; 302; 402; 502) forming a photodiode, which stack (102; 202; 302; 402; 502) comprises a photon-absorbing layer (116; 216; 316; 416; 516), wherein the photon-absorbing layer (116; 216; 316; 416; 516) is configured to generate charges in response to incident light on the photo-sensitive device (100; 200; 300; 400; 500), defining a photo-sensitive region (104; 204; 304; 404; 504), wherein a guard ring structure (140; 240; 340; 440; 540) is arranged along a boundary of the photo-sensitive region (104; 204; 304; 404; 504), said guard ring structure (140; 240; 340; 440; 540) comprising a third electrode layer (142; 242; 342; 442; 542) being physically and electrically separated from the first electrode layer (110; 210; 310; 410; 510), and an insulator layer (144; 244; 344; 444; 544), wherein the photo-sensitive device (100; 200; 300; 400; 500) is configured to apply a bias voltage (150; 250; 350; 450; 550) to provide an electric potential difference between the photo-sensitive region (104; 204; 304; 404; 504) and the guard ring structure (140; 240; 340; 440; 540), to thereby electrically suppress crosstalk.

## Description

### Technical field

The present description relates to a photo-sensitive device and a corresponding image sensor. The present inventive concept further relates to a method for operating a photo-sensitive device. In particular, the present inventive concept relates to a photo-sensitive device that enables crosstalk suppression, and a method for operating such a device.

### Background

Accurate capture and conversion of light into electrical signals are crucial for high-quality image reproduction. Conventional image sensors often suffer from a phenomenon known as crosstalk, which arises when unwanted electrical signals from adjacent pixels interfere with the signals generated by the targeted pixel. Crosstalk leads to reduced spatial resolution, color inaccuracies, and image artifacts, compromising the overall performance of an imaging system.

Various attempts have been made to mitigate crosstalk, such as increasing pixel spacing, implementing complex pixel structures, or employing post-processing algorithms. However, these solutions have been limited in their effectiveness and may introduce additional complexities and costs to the image sensor design.

Thin-film Photodiode (TFPD) imagers offer superior crosstalk reduction compared to traditional silicon Complementary-MOSFET image sensors (CIS). The advantage arises from the thinner photon-absorbing layer in the TFPD, reducing neighboring pixel interference. However, TFPD designs often have a single photodiode covering the entire Focal Plane Array (FPA), leading to electrical crosstalk due to interconnected pixels. In contrast, modern CIS designs use pixelation techniques and trench structures to decrease noise and crosstalk.

To address the issue of electrical crosstalk in TFPD imagers, techniques such as the introduction of guard rings around each pixel have been proposed. The guard ring is a physical structure strategically positioned at the periphery of a pixel, or a group of pixels on an image sensor, and is in direct contact with the photodiode. These structures are typically created by modifying the underlying semiconductor substrate or adding additional layers to the pixel layout. The primary function of the guard ring is to collect and dissipate both photoinduced and dark charge carriers generated at the pixel boundary region which is particularly contributing to electrical crosstalk, and thereby establish a conductive or insulating barrier between neighboring pixels.

However, traditional guard rings introduce a trade-off with photosensitivity. The presence of the guard ring intercepts and drains charge carriers generated near the pixel boundaries, leading to a loss of signal contribution from the pixel-peripheral region. In particular, guard rings typically struggle to effectively manage charges since prior approaches focus on draining or removing the charges, thereby limiting the effectiveness of the guard rings. In other words, commonly used designs of guard rings negatively impact the fill factor, i.e. the light-sensitive portion of the pixel area, thus reducing the overall sensitivity and efficiency of the image sensor. This has driven the need for more advanced crosstalk suppression methods.

Thus, there is a need for improved effective crosstalk suppression for photo-sensitive devices while still minimizing adverse impacts on photosensitivity.

### Summary

An objective of the present description is to provide a photo-sensitive device and image sensor that effectively suppresses crosstalk by actively managing charges generated by incident light.

Another objective is to enhance image quality by reducing crosstalk artifacts and unwanted electrical interference between pixels. The inventive concept aims to enable images with improved spatial resolution and reduced noise levels.

A further objective is to avoid, or at least mitigate, trade-offs in fill factor to ensure maximum efficiency in light capture while still effectively implementing the guard ring structure.

These and other objectives are at least partly met by the invention as defined in the independent claims. Preferred exemplifying embodiments are set out in the dependent claims.

According to an aspect, there is provided a photo-sensitive device comprising: a stack forming a photodiode, which stack comprises a photon-absorbing layer, wherein the photon-absorbing layer is configured to generate charges in response to incident light on the photo-sensitive device, defining a photo-sensitive region, wherein a first electrode layer and a second electrode layer are arranged on opposite sides of the photon-absorbing layer, wherein the first electrode layer and the second electrode layer are configured to provide an electric field for driving charges generated in the photon-absorbing layer towards a first node comprising the first electrode layer (110; 210; 310; 410; 510) and a second node comprising the second electrode layer (120; 220; 320; 420; 520), respectively, wherein a guard ring structure is arranged along a boundary of the photo-sensitive region, said guard ring structure comprising a third electrode layer being physically and electrically separated from the first electrode layer, and an insulator layer, wherein the photo-sensitive device is configured to apply a bias voltage to provide an electric potential difference between the photo-sensitive region and the guard ring structure, to thereby electrically suppress crosstalk.

By way of example, the charges generated in the photon-absorbing layer may flow towards, and accumulate at, the first node in the photo-sensitive device. In particular, the charges may be collected in the first and/or second electrode layers.

For example, the photodiode may generate a plurality of electron-hole pairs by absorption of photons of sufficient energy. An electric field is provided across the photodiode such that generated holes move towards a negative node at one side of the photodiode and electrons move towards a positive node at another side of the photodiode. The negative node and the positive node may be arranged at opposite sides of the photon-absorbing layer.

In a particular example, the photon-absorbing layer of the stack may comprise a material which is configured to absorb photons of sufficient energy corresponding to a wavelength of interest, e.g., infrared wavelengths. The photon-absorbing layer may be a thin-film layer. The stack may further comprise at least part of the first node and/or the second node. The stack may be configured to drive holes and electrons towards nodes on opposite sides of the photon-absorbing layer, respectively. The photon-absorbing layer may be sandwiched between the first node and the second node. In this regard, the stack may in a part comprise each of the first node, the photon-absorbing layer, and the second node. However, it should be realized that the layers may be diagonally arranged in the stack such that the first node is not necessarily overlapping the second node.

The nodes may comprise a material which is configured to allow a flow of charges of a particular sign within the node along a direction of the largest extension of the nodes. The nodes may be configured to transport charges of opposite signs. In other words, the first node and the second node may, respectively, act as charge transport layers.

The stack may be formed by layers arranged on top of each other. Each layer may have a shape like a sheet with a large extension in two dimensions and a much smaller extension transverse to the sheet. The layer may be planar with a large extension in two dimensions in a plane compared to a cross-sectional height perpendicular to the plane. However, it should be realized that the layer need not necessarily be completely planar. Rather, the layer may be at least partly bent or curved, while the layer is still arranged in an overall plane with a large extension in two dimensions and a small extension in a perpendicular direction to the other two dimensions. The thickness of a layer (i.e., extension transverse to the sheet) may be constant or may be varying over the sheet formed by the layer.

The layers may be stacked such that the small extensions of the layers are arranged on top of each other, whereby the layers are formed in parallel planes arranged on top of each other.

However, the layers need not have identical extensions in the planes arranged on top of each other. Thus, a cross-section of the photo-sensitive device may in some parts comprise all layers of the stack, whereas a cross-section of the stack may in other parts comprise only one or some layers of the stack.

As used herein, a horizontal direction of the stack or horizontally in the stack is used to describe a direction parallel to the planes of the stack, whereas a vertical direction of the stack or vertically in the stack is used to describe a direction perpendicular to the planes of the stack.

The layers of the stack may be formed by thin-film layer deposition. Thin-film layer deposition may be suitable for the monolithic integration of structures using a vast amount of materials, e.g., organic materials, colloidal quantum dots, and/or perovskites. This may be advantageously used in the photo-sensitive device, which may be suited for use of e.g., organic materials in light detection.

The stack may comprise further layers in addition to the photon-absorbing layer and/or the first and second nodes. Such further layers may have the same or a different extension to the first node, the photon-absorbing layer, and/or the second node. The further layers may be arranged in-between any two layers of the first node, the photon-absorbing layer, and the second node.

The guard ring structure is arranged along a boundary of the photo-sensitive region. In other words, the guard ring structure may be integrated at least partly along a perimeter or periphery of the photo-sensitive region of the photo-sensitive device. It is to be understood that the guard ring structure may not necessarily be a ring. The guard ring structure may at least partially surround the photo-sensitive region of the photo-sensitive device.

The integration of the guard ring structure may significantly reduce leakage currents, and may allow for maintaining accurate current control and reliable light detection. The guard ring may establish an isolation between the photo-sensitive region (i.e. an active region) of the photo-sensitive device and external surroundings thereof, thereby mitigating unintended electrical interactions and external influences, and preserving the inherent light sensitivity. The guard ring structure may minimize edge effects at the periphery of the photo-sensitive device, thereby reducing impact on operational dynamics.

The guard ring structure substantially attenuates crosstalk between the photo-sensitive region of the photo-sensitive device and other regions, devices, or arrangements in close proximity within external surroundings thereof, thus providing necessary isolation and minimizing inter-device interference in close-proximity arrangements.

Furthermore, the guard ring structure may optionally address dark currents, i.e., undesired flow of electric current that occurs in the absence of light stimulus. The integration of the guard ring structure, through management of charge pathways and controlled electric fields, may contribute to reduction in dark current levels.

Moreover, the guard ring structure may reduce noise and contribute to an improved signal-to-noise ratio.

The third electrode layer and the insulator layer may define the guard ring structure. In other words, the guard ring structure comprises at least an electrode layer and an insulating layer. The electrode layer of the guard ring structure may comprise any electrically conducting material (e.g. metal). The insulator layer may be a dielectric layer and/or any insulating layer (e.g. an oxide layer).

The guard ring structure helps to solve a crosstalk-photosensitivity dilemma of traditional guard ring approaches, which intercept and drain charge carriers generated near boundaries of a photo-sensitive device. In a sense, the insulator layer in the guard ring structure of the present description may act as a gate dielectric layer of a transistor and the third electrode layer in the guard ring structure may act as a gate electrode of a transistor. Hence, no charges are drained by the electrode of the guard ring and crosstalk is suppressed without draining photoinduced charge carriers. By turning off the guard ring transistor at all times, or at least during a part of an integration period of the photodiode, lateral charge transport through the boundary of the photo-sensitive region (i.e. pixel) is suppressed without draining the charges.

The bias voltage applied by the photo-sensitive device to the third electrode layer provides an electric potential difference between the photo-sensitive region and the guard ring structure. Bias or biasing may generally be defined as a mechanism of establishing and/or applying voltage at different positions of an electronic component to establish proper operating conditions.

The potential difference prevents charges from moving from the photo-sensitive region where they are generated to another part of the photosensitive device, in other words, charges are encouraged to only move within a specific part of the photo-sensitive device. The charges may therefore not travel between different, interconnected, photo-sensitive devices, such that electrical crosstalk between different photo-sensitive devices is suppressed. In other words, generated charges are confined to their intended areas and do not interfere with neighboring regions. Thus resulting in improved accuracy, enhanced image quality, higher signal-to-noise ratio, reduced artifacts, expanded dynamic range, and optimized device performance. These benefits collectively contribute to the overall quality, reliability, and longevity.

According to an exemplifying embodiment, each layer may define a geometric plane, and the insulator layer may be in the same geometric plane as the first electrode layer and/or the first node. In other words, the insulator layer may be arranged next to, and/or in connection with, the first electrode layer and/or the first node.

The third electrode layer may be embedded in insulating material such that the third electrode layer and the insulating material may form one geometric entity.

The first node, the second node, the first electrode layer, the second electrode layer, the third electrode layer, the insulator layer and/or other layer of the photo-sensitive device may, respectively, define a geometric plane. The first node may be a first node layer and/or the second node may be a second node layer. Each layer may define a distinct geometric plane. It is appreciated that a geometric plane may here be regarded as being substantially planar or have a curvature.

The insulator layer may extend in the geometric plane of the first electrode layer and/or the first node. That is, the geometric plane of the insulator layer may be the same geometric plane as the geometric plane defined by the first electrode layer and/or the first node. In other words, the insulator layer may have a thickness similar or identical to the first electrode layer and/or the first node. Alternatively, the insulator layer may have a thickness similar or identical to a thickness of the stacked, or combined, first electrode layer and the first node.

The insulator layer may separate or distinguish the first electrode layer and/or the first node of one photo-sensitive device from the first electrode layer and/or the first node of another photo-sensitive device. In other words, the insulator layer may isolate the first electrode layer and/or the first node of one photo-sensitive device from the first electrode layer and/or the first node of another photo-sensitive device.

According to an exemplifying embodiment, each layer may define a geometric plane, and the first electrode layer and the third electrode layer may be in the same geometric plane and separated by a recess consisting of an insulating material, or the third electrode layer may be spatially juxtaposed and situated directly adjacent to the insulator layer in the geometric plane defined by the first electrode layer. In other words, the electrode of the photo-sensitive region may be separated or divided from the electrode of the guard ring structure by an insulating material.

The insulating material may be the same material as the material of the insulator layer. The insulating material may form part of the insulator layer and/or be the insulator layer. The insulating material and the insulator layer may together form one insulating member. The guard ring structure may comprise an insulating member.

Alternatively, the third electrode layer may be arranged such that the geometric plane of the first electrode layer is between the geometric plane defined by the third electrode layer and the geometric plane of the first node. In other words, the geometric plane of the first electrode layer may be sandwiched between the geometric plane of the third electrode layer and the geometric plane of the first node. However, the first electrode layer may not necessarily be sandwiched between the third electrode and the first node. In other words, the first electrode layer and the third electrode layer may be laterally shifted with respect to each other.

According to an exemplifying embodiment, the stack may further comprise a first charge transport layer and a second charge transport layer, wherein the photon-absorbing layer may be arranged between the first charge transport layer and the second charge transport layer, and wherein the first charge transport layer and the second charge transport layer may be configured to transport charges of opposite signs to the first electrode layer and the second electrode layer, respectively. Each charge transport layer may define a geometric plane.

In other words, the stack may comprise two or more charge transport layers for the transport of charges of one or more signs. Hence, the stack may comprise two different materials for hole transport forming two charge transport layers and/or two different materials for electron transport forming two charge transport layers.

In a sense, the first and second nodes may, respectively, comprise components such as a first and a second charge transport layer in addition to the first and second electrode layers.

The stack may be configured to drive holes and electrons towards charge transport layers on opposite sides of the photon-absorbing layer, respectively, with the photon-absorbing layer being sandwiched between the first charge transport layer and the second charge transport layer. In this regard, the stack may in a part comprise each of the first charge transport layer, the photon-absorbing layer, and the second charge transport layer. However, it should be realized that the layers may be diagonally arranged in the stack such that the first charge transport layer is not necessarily overlapping the second charge transport layer.

The charge transport layers may comprise a material which is configured to allow a flow of charges of a particular sign within the charge transport layer along a direction of the largest extension of the charge transport layer. The charge transport layers may be configured to transport charges of opposite signs such that one of the first charge transport layer and the second charge transport layer may be an electron transport layer (ETL) and the other of the first charge transport layer and the second charge transport layer may be a hole transport layer (HTL).

It should be understood that the present invention may be realized without charge transport layers.

According to an exemplifying embodiment, the guard ring structure may further comprise a third charge transport layer configured to transport charges of the same sign as the first charge transport layer, wherein the insulator layer may be arranged between the third electrode layer and the third charge transport layer, or wherein the third charge transport layer may be arranged between the third electrode layer and the insulator layer. In other words, the insulator layer may be positioned between the third electrode layer and the third charge transport layer, or alternatively, the third charge transport layer may be positioned between the third electrode layer and the insulator layer.

According to an exemplifying embodiment, the first charge transport layer and the third charge transport layer may be one continuous charge transport layer, or the first charge transport layer and the third charge transport layer may be in the same geometric plane and separated by a recess consisting of an insulating material. In other words, the first charge transport layer and the third charge transport layer may be the same charge transport layer and may extend through or over both the photo-sensitive region and the guard ring of the photo sensitive device.

Hence, manufacturing of the photo-sensitive device may be facilitated by the ability to use one continuous charge transport layer.

Alternatively, the first charge transport layer and the third charge transport layer may be two distinct charge transport layers divided by an insulating material. The insulating material may be of the same material as the material of the insulator layer. The insulating material may form part of the insulator layer and/or be the insulator layer. The insulating material layer and the insulator layer may together form one insulating member.

According to an exemplifying embodiment, the photo-sensitive device may be configured to be connected to a power source, or the photo-sensitive device may comprise a power source for providing the bias voltage via the guard ring structure. In other words, the photo-sensitive device may establish a connection either with an external power source or, alternatively, to feature an integrated power source. Thus allowing for the facilitation of bias voltage provided via the guard ring structure.

The incorporation of an internal power source renders the device portable by removing the necessity for intricate external connections. Additionally, the internal power source may ensure consistent provision of the bias voltage, therby promoting accurate output. On the other hand, an external power source may simplify maintenance through effortless power source replacement.

According to an exemplifying embodiment, the photo-sensitive device may be configured to accumulate charges at the first node during an integration period, wherein the first node may be connected to a read-out circuit during a subsequent read-out period for reading out a signal representative of the incident light accumulated during the integration period on the photo-sensitive device.

It should be realized that it is desired that the potential of a node which is to be used for reading out a signal representative of incident light should vary during the integration period. Since a signal representative of incident light is to be read out, the signal needs to be dependent on an amount of incident light. Hence, the potential of the first node should inevitably be varying during the integration period.

The integration period is a duration of time during which charges are generated and accumulated. The charges may be continuously generated in the photon-absorbing layer and continuously accumulated at the first node during the integration period. The integration period may be defined as a duration of time between a reset of a voltage at the first node (optioanally connected to the first charge transport layer) and a readout of the voltage at the first node. Thus, an amount of charges accumulated during the integration period may be converted into a signal that is representative of light incident on the photo-sensitive device during a read-out period.

The photo-sensitive device may be configured to continuously generate and accumulate charges, whereas reset and readout signals or select signals may be used for enabling relating the signal being read out to a light intensity. However, it should be realized that the photo-sensitive device may further be arranged in relation to a shutter, a switch, a switching element a controller, and/or a timer, which may control whether or not light is allowed to reach the photo-sensitive device.

The first or second node being connected to a read-out circuit implies that an electrical and physical connection to the read-out circuit is provided at the second part of the photo-sensitive device. For instance, a metal wire physically connected to the read-out circuit may be physically connected to the first node and/or electrode layer of the photo-sensitive device.

The first node may, in some specific instances, be a floating diffusion node. At an end of the integration period, during a read-out period, a voltage signal at the first node may be selectively read out using the read-out circuit.

A potential of the first node, or the floating diffusion node, may be determined by an amount of accumulated charges stored in the floating diffusion node. The voltage signal may be read out at the floating diffusion node at the end of the integration period, in a subsequent read-out period, such that a signal corresponding to the amount of charges accumulated at the floating diffusion node during the integration period may be read out during the read-out period.

The reading out of the voltage signal at the floating diffusion node may be controlled by a select signal. The select signal may control a point in time at which the voltage signal at the floating diffusion node is read out. This may be used, e.g., for controlling an order in which signals from different photosensitive devices in an array are read out on a read-out line shared by the photo-sensitive devices.

Prior to the integration period, a voltage at the floating diffusion node may be reset using the read-out circuit. Thus, the voltage at the floating diffusion node may be reset before charges are accumulated at the floating diffusion node. Hence, by resetting the voltage at the floating diffusion node, a plurality of measurements, sequential in time, may be acquired of light intensity incident on the photosensitive device. Even if a single measurement of light intensity is made, the resetting of the voltage at the floating diffusion node may provide an accurate definition of the start of the integration time.

According to an exemplifying embodiment, the photo-sensitive region may be a pixel, wherein the electrically suppressed crosstalk may be pixel crosstalk. In other words, the photo-sensitive region may be analogous to a single pixel and the reduction of undesired electrical interference between neighboring pixels may be achived. Hence, the boundary of the photo-sensitive region may be a pixel boundary, and the guard ring structure may suppress crosstalk without significant loss of photosensitivity and form factor of the pixel.

Hereby, sharper and more accurate imaging is facilitated, and enhanced quality of visual data and optimal signal interpretation may be provided. Thus improving imaging technology related to, for example, data accuracy and image-based analyses.

According to an exemplifying embodiment, the photo-sensitive device may further comprise at least two different photo-sensitive regions. In other words, the photo-sensitive device may be comprising at least two different areas that are capable of sensing light. Thus, one or more guard ring structures may be arranged between the at least two different photo-sensitive regions and electric crosstalk between the at least two different photo-sensitive regions may hence be suppressed.

The photo-sensitive regions may be arranged laterally next to each other and/or the photo-sensitive regions may be stacked vertically.

The at least two different photo-sensitive regions may correspond to at least two pixels. Thus, the guard ring structure may suppress pixel crosstalk between the at least two pixels.

According to an exemplifying embodiment, the photo-sensitive device may have a lower electric potential along the boundary of the photo-sensitive region relative to the photo-sensitive region, wherein the first charge transport layer may be an electron transport layer, and the second charge transport layer may be a hole transport layer. In other words, the electrical potential level may be fixed lower at the guard ring structure than at the photo-sensitive region. The photo-sensitive device may have a lower electric potential along the boundary of the photo-sensitive region relative to the photo-sensitive region at all instances or at least during the integration period. The electric potential over the photo-sensitive device may form an electrical potential profile. The electrical potential profile may be characterized in that the electric potential is lower at the guard ring structure than at the photo sensitive region of the photo-sensitive device. The electric potential may be obtained by applying an anode bias to the third electrode layer of the guard ring structure. Hereby, lateral charge transport through the boundary of the photo-sensitive region may be prevented. Phrased differently, no signal charges (i.e. electron charge carriers) are drained, instead all photo- and dark-generated signal charge carriers are guided and collected at the photo-sensitive region. Hence, the guard ring structure may offer reduced crosstalk without major losses in photosensitivity and form factor of the photo-sensitive device.

In an alternative exemplifying embodiment, the photo-sensitive device may have a higher electric potential along the boundary of the photo-sensitive region relative to the photo-sensitive region, wherein the first charge transport layer may be a hole transport layer and the second charge transport layer may be an electron transport layer. In other words, the electrical potential level may be fixed higher at the guard ring structure than at the photo-sensitive region. The electric potential over the photo-sensitive device may form an electrical potential profile characterized in that the electric potential is higher at the guard ring structure than at the photo sensitive region.

Hereby, no signal charges (i.e. hole charge carriers) are drained, instead all photo- and dark-generated signal charges are guided and collected at the photo-sensitive region.

According to a second aspect, there is provided an image sensor comprising an array of photo-sensitive devices according to the first aspect. In other words, an image sensor equipped with a collection of photo-sensitive devices arranged in an array configuration is provided.

One or more guard ring structures of the photo-sensitive devices in the array of photo-sensitive devices may be arranged between the photo-sensitive devices in the array of photo-sensitive devices. Hereby, one or more of the guard ring structures of the photo-sensitive devices in the array of photo-sensitive devices may prevent or suppress electric crosstalk between the photo-sensitive devices in the array of photo-sensitive devices.

The array of photo-sensitive devices may be an array of pixels, and the suppressed electric crosstalk may be pixel crosstalk.

At least part of the effects and features of this second aspect are largely analogous to those described above in connection with the first aspect. Embodiments mentioned in relation to the first aspect are largely compatible with the second aspect.

According to an exemplifying embodiment, the second charge transport layer and the photon-absorbing layer may be continuous layers extending over a plurality of photo-sensitive devices of the array.

The second charge transport layer and the photon-absorbing layer may be formed from materials which may be difficult to pattern, such as materials that are sensitive to damage that may be caused by a patterning process. Hence, for ease of manufacturing, it may be advantageous that the second charge transport layer and the photo-absorbing layer are continuous layers extending over a plurality of photo-sensitive devices.

In other exemplifying embodiments, only one of the second charge transport layer and the photon-absorbing layer is a continuous layer.

According to another exemplifying embodiment, the second charge transport layer and the photon-absorbing layer are patterned such that the second charge transport layer of a first photo-sensitive device is physically separate from the second charge transport layer of a second photo-sensitive device, neighboring to the first photo-sensitive device and that the photon-absorbing layer of the first photo-sensitive device is physically separate from the photon-absorbing layer of the second photo-sensitive device.

This may be advantageous in further avoiding crosstalk between neighboring photo-sensitive devices.

According to an exemplifying embodiment, the first node, the photon-absorbing layer, and the second node of the photo-sensitive devices may be arranged on a semiconductor substrate comprising the read-out circuit for reading out the signals representative of the incident light on the photo-sensitive device.

This implies that the photo-sensitive device may be integrated with a substrate on which the read-out integrated circuit is provided. This ensures that the image sensor with read-out circuitry may be very compact and allows processing of detected signals in a small-scale device. The read-out integrated circuit may be used for reading out signals of a detected amount of light but may also be used for more advanced processing of the signals.

The read-out integrated circuit may be formed by semiconductor technology, such as using complementary metal-oxide-semiconductor (CMOS) circuitry. Thus, the image sensor may make use of existing technology for manufacturing of small-scale circuitry.

However, according to an alternative, the read-out integrated circuit may be designed by using thin-film technology.

According to a third aspect, there is provided a method of operating a photo-sensitive device according to the first aspect, the method comprising: providing an electric field for driving charges generated in the photon-absorbing layer towards the first node and the second node, respectively; and applying a bias voltage to provide an electric potential difference between the photo-sensitive region and the guard ring structure, to thereby electrically suppress crosstalk.

This aspect may generally present the same or corresponding advantages as the former aspects.

The electric field for driving charges generated in the photon-absorbing layer may be provided during all instances or at least during the read-out period.

The bias voltage may be applied at least during the integration period and/or the read-out period. The bias voltage may be switched on and off, though DC operation. Hence, less power consumption may be achieved by dynamic operation.

The steps of providing an electric field and applying a bias voltage may be performed by a controlled power source. In other words, the controlled power source may generate and regulate the electric field and the bias voltage within the photo-sensitive device.

The controlled power source may provide the capability to tune the sensitivity and reactivity of the photo-sensitive device to varying light conditions, and to tune the bias voltage such that crosstalk may be suppressed.

The controlled power source may comprise at least one controlled power source. The electric field and the bias voltage may be provided by different power sources.

### Brief description of the drawings

The above, as well as additional objects, features, and advantages of the present description, will be better understood through the following illustrative and non-limiting detailed description, with reference to the appended drawings. In the drawings like reference numerals will be used for like elements unless stated otherwise.
Figures 1A-E show cross-sectional side views of various embodiments of a photo-sensitive device having a guard ring structure.
Figure 2 shows a top view of an image sensor comprising photo-sensitive devices according to any of Figures 1A-E.
Figures 3A-E show cross-sectional side views of image sensors respectively comprising an array of at least two photo-sensitive devices according to Figures 1A-E.
Figure 4 shows a flow chart of a method for operating a photo-sensitive device.

### Detailed description

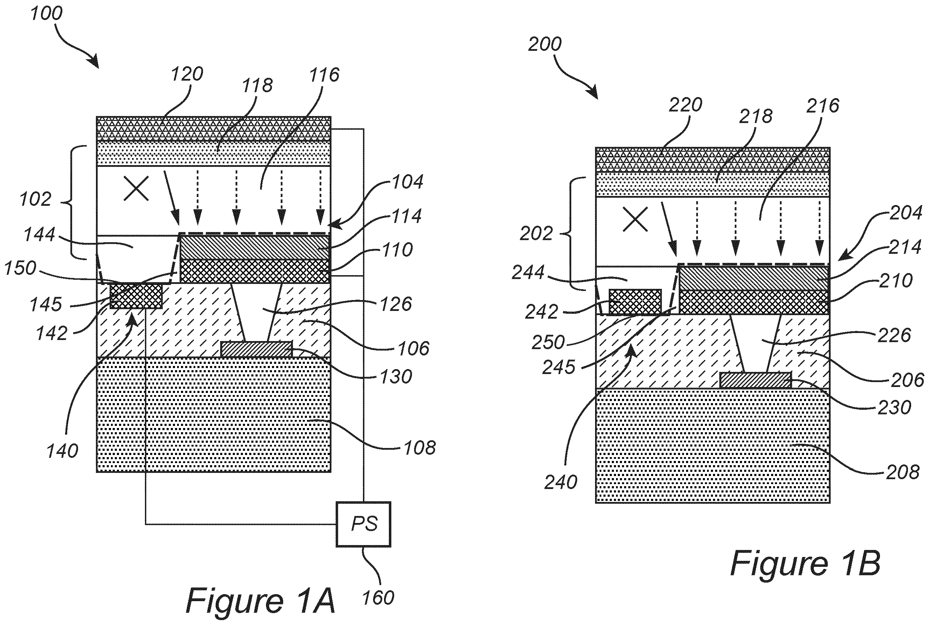

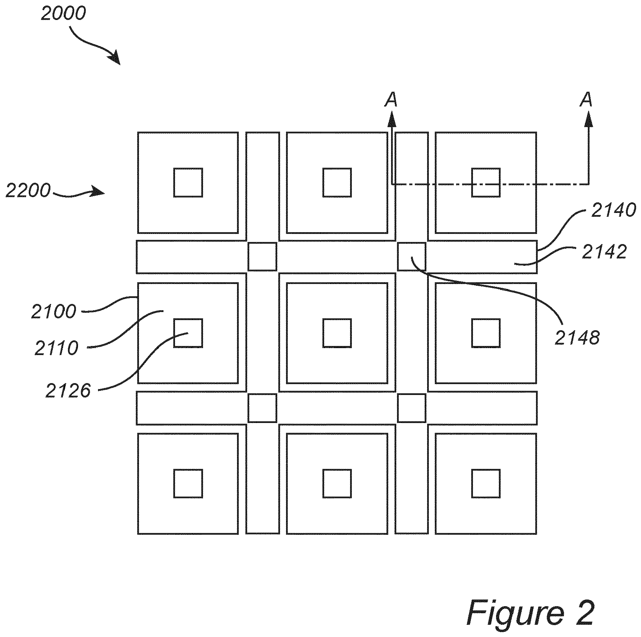

Figure 1A-E illustrates a cross-section of a photo-sensitive device 100 a taken along lines A-A in Figure 2. Figure 2 shows an array of photo-sensitive devices 100 forming an image sensor, which will be discussed later. However, it should be realized that the below discussion of the photo-sensitive device 100 of Figures 1A-E applies to a photo-sensitive device 100 which may be used in isolation and it not necessarily arranged in an array.

The photo-sensitive device 100 comprises a layer structure forming a stack 102 for detecting incident light and converting incident light to a signal corresponding to the amount of incident light.

The stack 102 of the photo-sensitive device 100 may be suitable for being formed by thin-film layer deposition. This may ensure that the photo-sensitive device 100 may be very compact and small-size and may also facilitate use of the photo-sensitive device 100 in combination with a read-out integrated circuit, which may also be formed using thin-film technology or which may be formed by semiconductor processing on a semiconductor substrate. It should however be realized that the stack 102 need not necessarily be formed using thin-film layer deposition.

The stack 102 may comprise a photon-absorbing layer 116, which may be configured to absorb light and generate charges based on the absorbed light. Thus, electron-hole pairs may be generated in the photon-absorbing layer 116 based on light being absorbed. The electron charges and hole charges may be transferred to respective charge transport layers 114, 118 on opposite sides of the photon-absorbing layer 116 such that the photon-absorbing layer 116 may be sandwiched between the charge transport layers 114, 118. Thus, generated electron charges may be transferred to a first charge transport layer forming an electron transport layer 114 and generated hole charges may be transferred to a second charge transport layer forming a hole transport layer 118, such that the stack 102 of photon-absorbing layer 116 and the charge transport layers 114, 118 form a photodiode.

However, it should be understood that the present invention may be realized without the charge transport layers 114, 118.

The photo-sensitive device 100 may comprise a first electrode layer 110 and a second electrode layer 120 on opposite sides of the stack 102 including the charge transport layers 114, 118 and the photon-absorbing layer 116. The first electrode layer 110 and the second electrode layer 120 may be configured to provide an electric field for driving charges generated in the photon-absorbing layer 116 towards the electron transport layer 114 and hole transport layer 118, respectively.

Thus, when light is incident on the photon-absorbing layer 116, electron charges will here be generated (during the integration period and until signal saturation) and accumulated in the electron transport layer 114, whereas hole charges may be transported to the hole transport layer 118 and be drained (during the read-out period and/or at all instances before signal saturation) through the second electrode layer 120. The accumulation of charges in the electron transport layer 114 and the hole transport layer 118 prevents or at least reduces recombination of holes and electrons in the photon-absorbing layer 116 to ensure that a high efficiency in light detection is provided by the photo-sensitive device 100.

The photon-absorbing layer 116 may be sensitive to a range of wavelengths of light. The range of wavelengths may be narrow to allow detection of a specific wavelength, but the range of wavelengths may alternatively be broad such that the photo-sensitive device 100 may be able to generally detect an amount of light over a broad range, such as covering the range of visible light and extending into the range of infrared light. In the latter case, the photo-sensitive device 100 may be combined with a filter such that the filter may select which range of wavelengths that should be detected by the photo-sensitive device 100. Also, having a photon-absorbing active layer 116 which is sensitive to a broad range of wavelengths would allow using the same type of photon-absorbing layer 116 within an array of photo-sensitive devices 100, wherein different photo-sensitive devices 100 in the array may be associated with different filters for providing spectrally resolved imaging. Hence, spectrally resolved imaging would not require using different materials for the photon-absorbing layer 116 in different photo-sensitive devices 100.

In particular, the photon-absorbing layer 116 may be formed from a material which is sensitive to wavelengths in the infrared range. Thus, the photo-sensitive device 100 may be used for infrared detection, which may not be achieved with photo-sensitive devices using silicon for light detection. Thus, the photo-sensitive device 100 may be particularly interesting to use for detection of infrared light. However, it should be understood that the photo-sensitive device 100 may also be well suited for detection of visible light by proper selection of a material of the photon-absorbing layer 116.

A material of the photon-absorbing layer 116 may be selected from various materials. In particular, the photo-sensitive device 100 is well suited for using an organic material in the photon-absorbing layer 116, such as an organic semiconductor material. Alternatively, the photon-absorbing layer 116 may be made of a perovskite material, and/or a combination of organic and inorganic materials.

The photon-absorbing layer 116 may, for example, comprise a quantum dot, such as a quantum dot based on lead sulfide (PbS), lead selenide (PbSe) indium arsenide (InAs), copper selenide (CuSe), or indium antimonide (InSb) or an organic photodetector material. Such materials may be suitable for use in manufacturing of the photo-sensitive device 100 using thin-film technology. Also, such materials may be used for selecting a sensitivity of wavelengths of light of the photo-sensitive device 100 to enable using the photo-sensitive device 100 in various applications spanning a broad range of wavelengths of light from ultraviolet light to infrared light.

However, it should be understood that the photo-sensitive device 100 is not necessarily limited to use of the particular examples of materials of the photon-absorbing layer 116 provided herein. Rather, other materials may also be available and used with the photo-sensitive device 100.

As mentioned above, the first charge transport layer 114 arranged closest to the first electrode layer 110 may be an electron transport layer 114. The electron transport layer 114 may for instance be formed by a titanium oxide, zinc oxide, or indium-gallium-zinc oxide (IGZO).

Further, the second charge transport layer 118 arranged closest to the second electrode layer 120 may be a hole transport layer 118.

However, according to another exemplifying embodiment, the first charge transport layer 114 arranged closest to the first electrode layer 110 may instead be a hole transport layer. The hole transport layer 114 may for instance be formed by poly(3,4-ethylenedioxythiophene) polystyrene sulfonate (PEDOT:PSS), molybdenum oxide, nickel oxide, or poly(4-butylphenyl-diphenylamine) (poly-TPD).

Further, in such exemplifying embodiment, the second charge transport layer 118 arranged above the photon-absorbing layer 116 is an electron transport layer 118.

The light to be detected may be incident on the second electrode layer 120 arranged above the photon-absorbing layer 116 such that light encounters the second electrode layer 120 before reaching the photon-absorbing layer 116.

The second electrode layer 120 may be formed from a material that is transparent to relevant wavelengths (to be detected by the photo-sensitive device 100) to ensure that the light is passed to the photon-absorbing layer 116 for detection with high sensitivity. For instance, the second electrode layer 120 may be formed by indium tin oxide.

The first electrode layer 110 and the second electrode layer 120 may be configured to control a potential of the nodes and/or the charge transport layers 114, 118 and the photo-absorbing layer 116 to control function of the photo-sensitive device 100.

The first electrode layer 110 may, e.g., be formed by a metal or polysilicon. The first electrode layer 110 may thus be well suited for being formed by semiconductor processing on a semiconductor substrate. Such semiconductor substrate 108 may be combined with the layers of the stack 102 by forming these layers on top of the semiconductor substrate using thin-film layer deposition.

The photodiode (i.e. the stack 102) is connected to a read-out circuit via an electrical connection 126 and the first electrode layer 110. The read-out circuit may be integrated into the semiconductor substrate 108, and a contact pad 130 on the semiconductor substrate 108 may connect the photodiode to the read-out circuit. In other words, the contact pad 130 may be part of the electrical connection 126 between the photodiode and the read-out circuitry. Hence, the first electrode layer 110 may be connected to the read-out circuit through the electrical connection 126 and the electrical contact element 130. The electrical connection 126 may be a deep metal. The read-out circuit may comprise transistors for reading out a signal from the photo-sensitive device 100.

The photo-sensitive device 100 is configured to generate charges by the photon-absorbing layer 116 in response to incident light on the photo-sensitive device 100. The photo-sensitive device 100 is further configured to accumulate the generated charges at the first charge transport layer 114 during the integration time.

The first electrode layer 110 provides a potential for affecting a voltage bias of the photodiode. The first electrode layer 110 may be controlled to set a fixed potential of the first electrode layer 110 during the integration time. Hence, the first electrode layer 110 is set to a constant potential during the integration time.

The first electrode layer 110 will affect the voltage bias of the photodiode and controls the voltage bias of the photo-sensitive region 104 of the photo-sensitive device.

The photo-sensitive device 100 enables providing a constant voltage bias of the photodiode for providing an electric field during the integration time such that the photodiode may provide a linear response to incident light during integration time. Further, the potentials of the first electrode layer 110 and the second electrode layer 120 may be set such that the voltage bias of the photodiode provides a high light sensitivity with a low dark current.

At all instances before signal saturation, or at least during the read-out period, the potentials of the first electrode layer 110, the second electrode layer 120 and the first charge transport layer 114 may be controlled such that charges of one sign (e.g., electrons) are transported to the first charge transport layer 114 and charges of an opposite sign (e.g., holes) are transported to the second charge transport layer 118. Further, the potentials of the first electrode layer 110 and the second electrode layer 120 are set to provide a desired voltage bias of the photodiode.

Thus, the potential of the first electrode layer 110 may be set in relation to the potential of the first charge transport layer 114 such that charges to be accumulated in the first charge transport layer 114 are transported towards the first charge transport layer 114 during the integration period.

Further, the potential of the second electrode layer 120 may be set in relation to the potential of the first electrode layer 110 such that charges to be accumulated in the first charge transport layer 114 are transported in the photon-absorbing layer 116 towards the first charge transport layer 114 during the integration period.

If electrons are to be transported towards the first charge transport layer 114 during the integration time, the potential of the first electrode layer 110 should be smaller than the smallest potential assumed by the first charge transport layer 114 during the integration time. The potential of the first electrode layer 110 may be a negative voltage with the potential of the first charge transport layer 114 being initially set to ground when resetting.

Further, if electrons are to be transported towards the first charge transport layer 114 during the integration time, holes are to be transported towards the second charge transport layer 118. Hence, a potential of the second electrode layer 120 should be set to be even smaller than the potential of the first electrode layer 110.

It should be realized that if holes are instead to be transported towards the first charge transport layer 114, the potentials should set in an opposite relation with the potential at the first charge transport layer 114 being lower than the potential of the first electrode layer 110, and the potential of the first electrode layer 110 being lower than the potential of the second electrode layer 120.

It is appreciated that the above reference to the charge transport layer(s) 114, 118 may be regarded as interchangeable with the term node(s). In an example, a first and a second node may, respectively, comprise the first and second charge transport layers 114, 118.

The photo-sensitive region 104 of the photo-sensitive device 100 may be defined as a part of the photo-sensitive device 100 associated with a region of the first electrode layer 110, which is connected via the electrical connection 126 and the contact pad 130 to the read-out circuit integrated in the semiconductor substrate 108.

As mentioned above, the stack 102 may be formed using thin-film layer deposition on top of a semiconductor substrate 108. The read-out circuit may be formed as an integrated circuit which may be formed by semiconductor technology, such as using complementary metal-oxide-semiconductor (CMOS) circuitry. Thus, the photo-sensitive device 100 may make use of existing technology for manufacturing of small-scale circuitry.

The stack 102 may be integrated with a substrate 108 on which read-out integrated circuit is provided. This ensures that the photo-sensitive device 100 with read-out circuit may be compact and allow for processing of detected signals in a small-scale device. The read-out integrated circuit may be used for reading out signals of detected amount of light and may also be used for more advanced processing of the signals.

The photo-sensitive device 100 may be integrated on a silicon CMOS wafer, on which a read-out integrated circuit is formed. However, it should be realized that the photo-sensitive device 100 may alternatively be formed on other substrates, such as a thin-film technology wafer, which may, for example, use organic materials and on which the read-out integrated circuit may be formed.

The substrate 108 comprising the read-out circuit may be provided with a top insulating layer 106 and via electrical connections 126 through the top insulating layer 106 for providing contact with the read-out circuit through the insulating layer. Further, a metal layer may be formed on the top insulating layer 106 and the metal layer may then be patterned to form the first electrode layer 110 and/or the electrical connection 126. The first electrode layer 110 may be connected to the read-out circuit such that a control signal for setting the potential of the first electrode layer 110 may be provided through the read-out circuit. Further, the electrical connection 126 is connected to the contact pad 130 connected to the read-out circuit to allow accumulated charges at the first charge transport layer 114 to be read out to the read-out circuit.

Further, a dielectric material layer (which may be different from the insulating material of the top insulating layer 106 between the first electrode layer 110 and via electrical connections 126) may be formed on the metal layer. This dielectric material layer may provide a dielectric material that separates the first electrode layer 110 from the stack 102 (not shown). The dielectric material layer may be patterned to provide access to the first electrode layer 110 through the dielectric material layer via the electrical connection 126 and contact pad 130 towards the read-out circuit. Then, the layers of the stack 102 may be formed on the semiconductor substrate 108, wherein the first charge transport layer 114 may extend through the dielectric material layer such that the first charge transport layer 114 is electrically connected to the electrical connection 126.

In Figure 1A, the guard ring structure 140 is arranged along the boundary of the photo-sensitive region 104. Here, the guard ring structure 140 is comprised by a third electrode layer 142 being physically and electrically separated from the first electrode layer 110, and an insulator layer 144.

The insulator layer 144 is in the same geometric plane as the first charge transport layer 114 and the first electrode layer 110. Hence the insulator layer 144 has a thickness similar to the thickness of the first charge transport layer 114 and the first electrode layer 110 together.

The third electrode layer 142 is spatially juxtaposed and situated directly adjacent to the insulator layer 144 being in the geometric plane defined by the first electrode layer 110. In other words, in this particular orientation of the photo-sensitive device 100, the third electrode layer 142 is positioned alongside, yet below, the first electrode layer 110. Phrased differently, the third electrode layer 142 is positioned directly below the geometric plane of the first electrode layer 110 and the insulator layer 144.

The insulator layer 144 is here provided, i.e. formed, on top of the third electrode layer 142. Hence, the insulator layer 144 will separate the third electrode layer 110 from the stack 102.

The third electrode layer 142 further has a width smaller than a width of the insulator layer 144. In particular, the third electrode layer 142 is centrically aligned with a center of the insulator layer 144. However, it is appreciated that the third electrode layer 142 may have a width equal or similar to the width of the insulator layer 144. The third electrode layer 142 may not need to be centrically aligned with the insulator layer 144, the third electrode layer 142 may, e.g., be offset.

The substrate 108, having the read-out circuit and being provided with a top insulating layer 106, may be patterned with an electrode (or metal) layer in a top portion thereof for forming the third electrode layer 142.

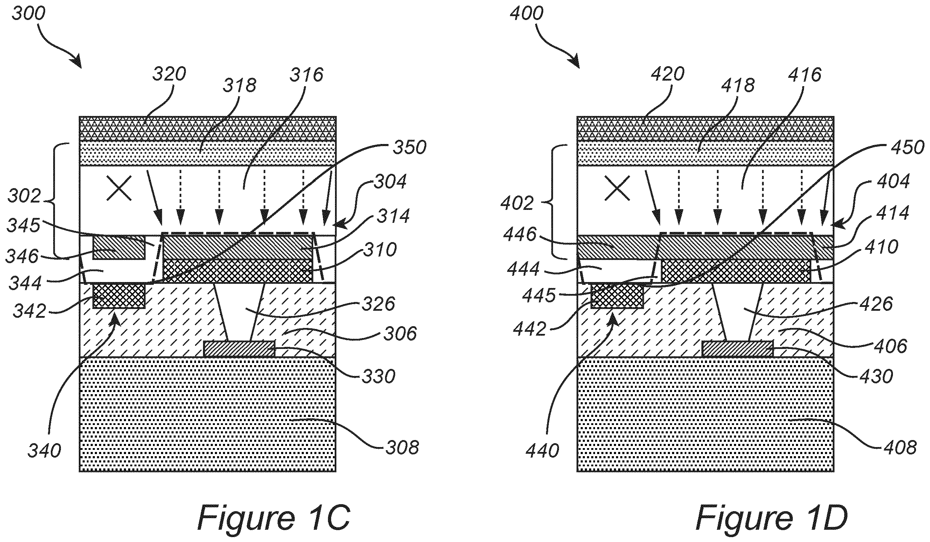

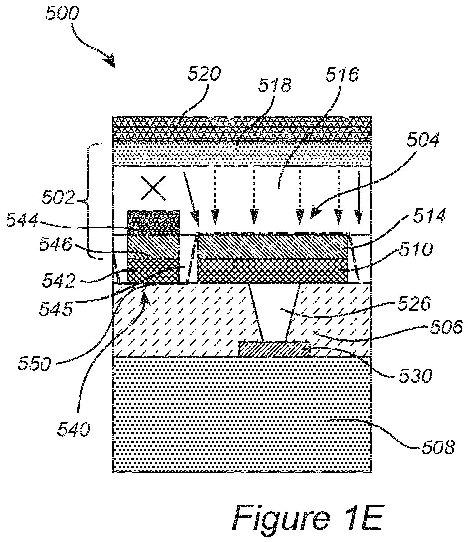

The width of a layer may be intended to indicate the lateral extension of the layer as seen in a cross-section of the photo-sensitive device 100, e.g., such as seen in Figures 1 and 2. Notably, the widths and dimensions of the components and features illustrated in figures may not be in scale.

The photo-sensitive device 100 has a bias voltage 150 which provides an electric potential difference between the photo-sensitive region 104 and the guard ring structure 140 of the photo-sensitive device 100. The bias voltage 150 may electrically suppress crosstalk. In particular, the bias voltage 150 may encourage charges to only accumulate at the photo-sensitive region 104.

Here, the bias voltage 150 provides a lower electric potential at the guard ring 140 and a higher potential at the photo-sensitive region 104. Hence, electron charges are accumulated at the first charge transport layer 114. In other words, the photo-sensitive device 100 may have a lower electric potential along the boundary of the photo-sensitive region 104 relative to photo-sensitive region 104. The first charge transport 114 layer may thus be an electron transport layer and the second charge transport layer 118 may be a hole transport layer.

Although not shown, the bias voltage 150 may alternatively provide a higher potential at the guard ring structure 140 and a lower potential at the photo-sensitive region 104 such that hole-charges may accumulate at the first charge transport layer 114. Thus, the first charge transport 114 layer may be a hole transport layer and the second charge transport layer 118 may be an electron transport layer.

By way of example, a power source 160 provides the bias voltage 150 to the photo-sensitive device 100 via the guard ring structure 140.

The power source 160, or any voltage supply, may be connected to an anode and/or cathode (here the first electrode layer 110 and the second electrode layer 120) of the photodiode to provide for the electric field for driving charges generated in the photon-absorbing layer 116 towards the first charge transport layer 116 or the second charge transport layer 118.

Additionally, the power source 160 may be connected for providing a bias voltage 150 via the guard ring structure 140 to provide an electric potential difference between the photo-sensitive region 104 and the guard ring structure 140 for electrically suppressing crosstalk. Alternatively, the power source 160 may be comprised by the photo-sensitive device 100.

Although not shown in the subsequent figures, it is appreciated that the photo-sensitive device 100 in any embodiment may be connected to a power source 160.

In Figure 1B, the guard ring structure 240 of the photo-sensitive device 200 is positioned along a boundary of the photo sensitive region 204. The insulator layer 244 is seen to be in the same geometric plane as the first charge transport layer 214. The third electrode layer 242 of the guard ring structure 240 is aligned with the first electrode layer 210. In particular, the geometric planes of the first electrode layer 210 and the third electrode layer 242 coincides.

The first electrode layer 210 and the third electrode layer 242 are further in the same geometric plane and separated by a recess consisting of an insulating material 245.

Further, the metal layer formed on the top insulating layer 206 may be patterned to form the first electrode layer 210, the third electrode layer 242, and/or the electrical connection 226. The electrical connection 226 may be formed separately before forming the first electrode layer 210 and the third electrode layer 242. The insulating material 245 (which may be the same or different from the insulating material of the insulator layer 244) may be used for providing insulation within the metal layer between the first electrode layer 210 and the third electrode layer 242.

The insulator layer 244 and/or the insulating material may be comprised by a material such as silicon dioxide, silicon nitride or a high-κ material such as hafnium oxide or aluminum oxide.

The insulator layer 244 is here formed on the third electrode layer 242. The insulator layer 244 and the insulating material 245 in the recess between the first electrode layer 210 and the third electrode layer 242 may be of the same insulating material such that an insulating member of the guard ring structure 240 is formed. The insulating member may partially surround the third electrode layer 242 such that the third electrode layer 242 is insulated from the photon-absorbing layer 216 and the first electrode layer 210.

The applied bias voltage 250 provides an electric potential difference between the photo-sensitive region 204 and the guard ring structure 240 such that electric crosstalk is suppressed.

Figure 1C benefits from the same discussion as Figure 1A. However, here, the guard ring structure 340 further comprises a third charge transport layer 346 of the same type as the first charge transport layer 314.

The first charge transport layer 314 and the third charge transport layer 346 are in the same geometric plane and separated by a recess consisting of an insulating material 345. The first charge transport layer 314 and the third charge transport layer 346 may be formed from one patterned charge transport layer.

As further seen in Figure 1C, the insulator 344 layer is arranged between the third electrode layer 342 and the third charge transport layer 346. In particular, the insulator layer 344 is arranged in the same geometric plane as the first electrode layer 310.

The insulating material 345 separating the first charge transport layer 314 and the third charge transport layer 346 may be the of the same or different insulating material as the insulator layer 344. The insulating material 345 of the recess may be used for providing insulation between the first charge transport layer 314 and the third charge transport layer 346.

The insulator layer 344 and the insulating material 345 in the recess, between the first charge transport layer 314 and the third charge transport layer 346, may be of the same insulating material such that an insulating member of the guard ring structure 340 is formed. The insulating member may at least partially surround the third charge transport layer 346 such that the third charge transport layer 346 is insulated from the first charge transport layer 314 and the third electrode layer 342.

Figure 1D benefits from the same discussions as Figures 1A and 1C. However, in Figure 1D, the first charge transport layer 414 extends over the guard ring structure 440. Thus, the first charge transport layer 414 and the third charge transport layer 446 are one continuous charge transport layer which extends over the whole photo-sensitive device 400.

Hence, the first charge transport layer 414, the photon-absorbing layer 416 and the second charge transport layer 418 all extend over both the photo-sensitive region 404 and the guard ring 440 of the photo-sensitive device 400.

Further, the insulator 444 layer is arranged in the geometric plane of the first electrode layer 410 and between the third electrode layer 442 and the third charge transport layer 446. Thus, the third electrode layer 442 is isolated from the third charge transport layer 446.

Figure 1E benefits form the same discussion as Figure 1B and 1C. However, here the third charge transport layer 546 is arranged between the third electrode layer 542 and the insulator layer 544. In particular, the third electrode layer 542 is in the same geometric plane as the first electrode layer 510, the third charge transport layer 546 is in the same geometric plane as the first charge transport layer 514, and the insulator layer 544 is provided in the photon absorbing layer 516 and upon the third charge transport layer 546.

The first electrode layer 510 and the third electrode layer 542 are further separated by a recess consisting of an insulating material 545, and the first charge transport layer 514 and the third charge transport layer 546 separated by a recess consisting of an insulating material 545. Thus, the first charge transport layer 514 and the third charge transport layer 546 may be formed from one patterned charge transport layer, and the first electrode layer 510 and the third electrode layer 542 may be formed from one patterned electrode layer. In other words, the guard ring structure 540 is here completely separated from the photo-sensitive region 504 by a recess of insulating material 545.

Alternatively, although not shown, the insulator layer 544 may be arranged between the third electrode layer 542 and the third charge transport layer 546 such that the third electrode layer 542 is in the same geometric plane as the first electrode layer 510, and such that the insulator layer 544 is in the same geometric plane as the first charge transport layer 514, and the third electrode layer 546 may be provided in the photon absorbing layer 516 and upon the insulator layer 544. Thus, the first electrode layer 510 and the third electrode layer 542 may be formed from one patterned electrode layer. In other words, the guard ring structure 540 may be completely separated from the photo-sensitive region 504 by a recess of insulating material 545.

The insulating material 545 in the recess between the guard ring structure 540 and the photo-sensitive region 504 may be of the same material as the insulator layer 544, and may insulate the guard ring structure 540 from the photo-sensitive region 504.

The insulating material 145, 245, 345, 445, 545 may be regarded as part of the guard ring structure 140, 240, 340, 440, 540, or the insulating material 145, 245, 345, 445, 545 may be regarded as an additional insulating material that may not be part of guard ring structure 140, 240, 340, 440, 540.

Furthermore, the photo-sensitive device 100, 200, 300, 400, 500 may be configured to accumulate charges at the first charge transport layer 114, 214, 314, 414, 514 during an integration period. The first charge transport layer 114, 214, 314, 414, 514 in Figures 1A-E is connected to a read-out circuit at all instances, or at least during a read-out period, for reading out a signal representative of the incident light during the integration period on the photo-sensitive device 100, 200, 300, 400, 500.

The read-out circuitry may be implemented as any suitable read-out circuit according to well-accepted technology. By way of example, the read-out circuit may be based on a floating diffusion node, a reset transistor, a source follower transistor and/or a select transistor. In a particular example, the floating diffusion node may be reset by applying a high voltage to a gate of reset transistor. Then, the floating diffusion node may accumulate charges generated from the photodiode and continue to accumulate charges during an integration time. The floating diffusion node may be connected to a gate of the source follower transistor and the accumulated charges may be read as a voltage signal via the source follower transistor while the select transistor is turned on by a signal on the gate of the select transistor.

In any one or more of the disclosed embodiments, the photo-sensitive region 104, 204, 304, 404, 504 may be a pixel such that the electrically suppressed crosstalk may be suppressed pixel crosstalk.

Referring now to Figure 2, the photo-sensitive device 2100 may be used in an array 2200. The array 2200 may thus enable detection of a plurality of signals representative of incident light on respective photo-sensitive devices 2100 in the array 2200. This may for instance be used for acquiring a spatially and/or spectrally resolved image. The array 2200 of photo-sensitive devices 2100 may thus for instance be used in an image sensor 2000.

Figure 2 shows a top view of an image sensor 2000 comprising an array 2200 of photo-sensitive devices 2100. For clarity, Figure 2 shows the first electrode layers 2110 and via electrical connections 2126 of the photo-sensitive devices 2100. The guard ring structure 2140 at least partially surrounds the photo-sensitive devices 2100. The guard ring structure 2140 is here partly shared with several photo-sensitive devices 2100 (or pixels). However, each photo-sensitive device 2100 may have a separate and/or distinct guard ring structure 2140.

The electric crosstalk between adjacent or neighboring photo-sensitive devices 2100 may be suppressed by the guard ring structure 2140. Further, the guard ring structure 2140 is illustrated to comprise the third electrode layer 2142 and electrical guard ring connections 2148 Attached thereto. The electrical guard ring connections 2148 may be through which the power source provides a potential to the guard ring structure 2140. Thus, the bias voltage of the photo sensitive device 2100 may be obtained.

The photon-absorbing layer 116, 216, 316, 416, 516 and the second charge transport layer 118, 218, 318, 418, 518 may be arranged as continuous layers extending over a plurality of photo-sensitive devices 100, 200, 300, 400, 500, 2100 of the arrays 2200, such as extending over the entire array 2200. The first charge transport layer 114, 214, 314, 414, 514 may also be arranged as a continuous layer extending over a plurality of photo-sensitive devices 100, 200, 300, 400, 500, 2100 of the arrays 2200, such as extending over the entire array 2200. Hence, the third charge transport layer 346, 446, 546 and the first charge transport layer 314, 414, 514 may be one and the same charge transport layer.

The photo-sensitive devices 2100 in the array 2200 may thus be defined by the first electrode layers 2110 of neighboring photo-sensitive devices 2100 separated by an insulating material. In particular, the insulating material separating the photo-sensitive devices 2100 may be comprised by the guard ring structure 2140, and/or the guard ring structure 2140 may separate neighboring photo-sensitive devices 2100.

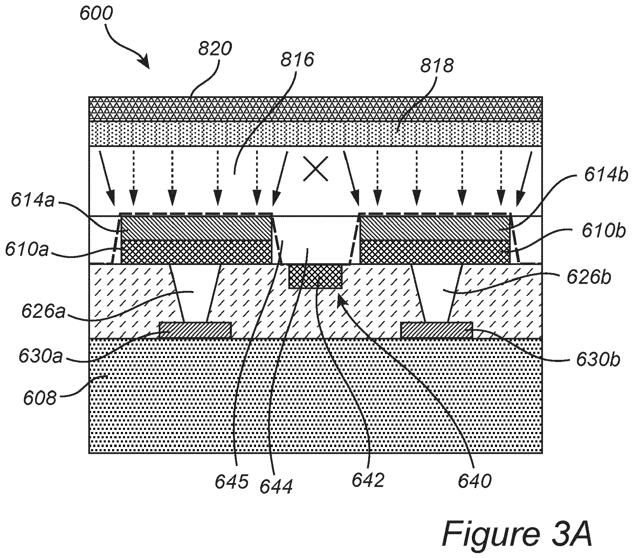

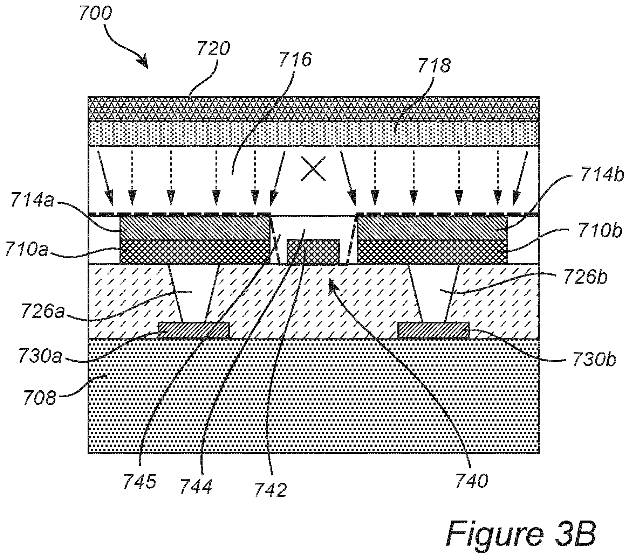

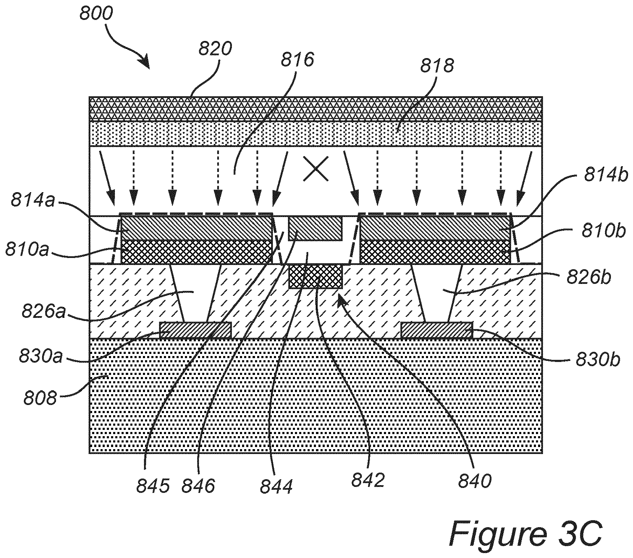

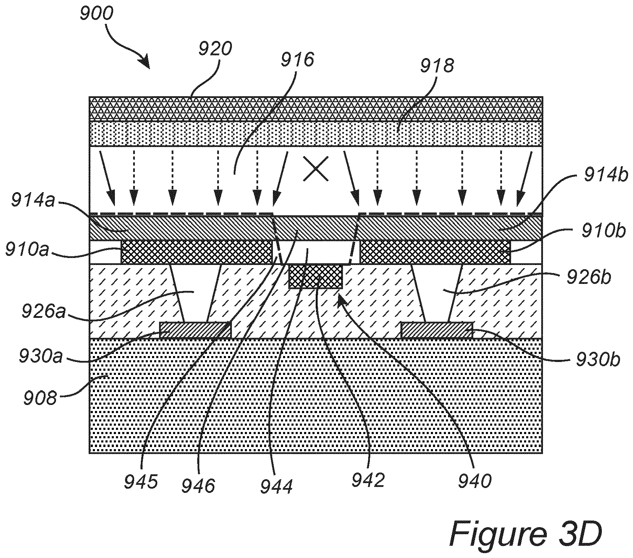

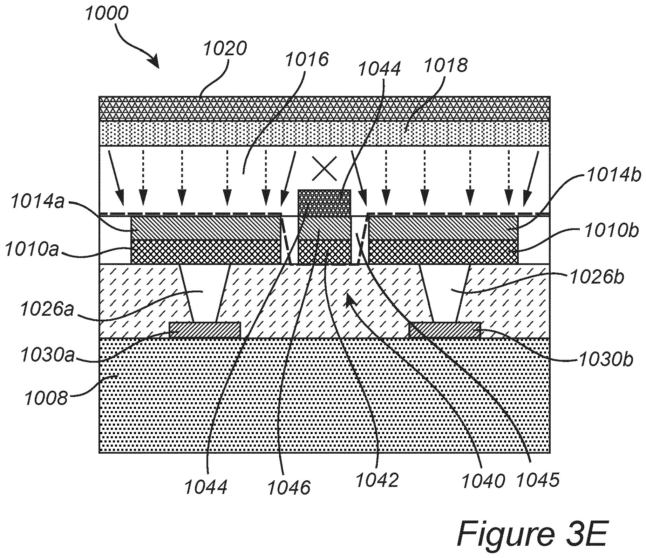

Referring now to Figures 3A-E, a cross-section of two photo-sensitive devices 100, 200, 300, 400, 500 of an arrays 600, 700, 800, 900, 1000 is shown. Figures 3A-E illustrate alternative exemplifying embodiments to the array 2200 shown in Figure 2. The array may comprise at least two photo-sensitive regions 104, 204, 304, 404, 504. In the array 600, 700, 800, 900, 1000 of photo-sensitive devices, the guard ring structure 640, 740, 840, 940, 1040 isolates neighboring photo-sensitive devices such that crosstalk between neighboring photo-sensitive devices is suppressed.

The isolation of the neighboring photo-sensitive devices by the guard ring structure 640, 740, 840, 940, 1040 may be obtained by pattering the first electrode layer 610a-b, 710a-b, 810a-b, 910a-b, 1010a-b and/or the first charge transport layer 614a-b, 714a-b, 814a-b, 914a-b, 1014a-b. In other words, the isolation and layers of the guard ring structure 640, 740, 840, 940, 1040 may be provided by forming trenches through the first electrode layer 610a-b, 710a-b, 810a-b, 910a-b, 1010a-b and/or the first charge transport layer 614a-b, 714a-b, 814a-b, 914a-b, 1014a-b and filling the trenches with an insulating material 645, 745, 745, 845, 934, 1045 preventing charges to travel across the trenches. Thus forming one first charge transport layer 614a, 714a, 814a, 914a, 1014a, another first charge transport layer 614b, 714b, 814b, 914b, 1014b, and/or a third charge transport layer 646, 746, 846, 946, 1046, as well as alternatively forming one first electrode layer 610a, 710a, 810a, 910a, 1010a, another first electrode layer 610b, 710b, 810b, 910b, 1010b, and/or a third electrode layer 642, 742, 842, 942, 1042. Hence, the guard ring structure 640, 740, 840, 940, 1040 may be formed by pattering, forming trenches, and/or filling trenches in the layers 610a-b, 710a-b, 810a-b, 910a-b, 1010a-b, 614a-b, 714a-b, 814a-b, 914a-b, 1014a-b.

The first charge transport layer 614a-b, 714a-b, 814a-b, 914a-b, 1014a-b may be isolated between neighboring photo-sensitive devices while the photon-absorbing layer 616, 716, 816, 916, 1016 and the second charge transport layer 618, 718, 818, 918, 1018 may extend continuously over neighboring photo-sensitive devices. This may prevent transfer of charges in the first charge transport layer 614, 714, 814, 914, 1014 between neighboring photo-sensitive devices.

It should be realized that isolations by trenches may be provided between neighboring photo-sensitive devices for each or some of the layers in the array 600, 700, 800, 900, 1000.

As previously mentioned, the first charge transport layer 614a-b, 714a-b, 814a-b, 914a-b, 1014a-b, the photon-absorbing layer 616, 716, 816, 916, 1016 and the second charge transport layer 618, 718, 818, 918, 1018 of the photo-sensitive devices may be arranged on the semiconductor substrate 608, 708, 808, 908, 1008 comprising the read-out circuit for reading out the signals representative of the incident light on the respective photo-sensitive devices. This implies that the array 600, 700, 800, 900, 1000 or the array 2200 of the photo-sensitive devices with read-out circuit may be compact and allows for forming an image sensor in a small-scale device. In particular, in figures 3A-E, the semiconductor substrate 608, 708, 808, 908, 1008 comprises a first read-out circuit, and a second read-out circuit.

The insights, features, and advantages explained in relation to Figures1A-E can further be seamlessly extended to Figures 3A-E, and vice versa. In particular, Figures 3A-E each benefit from the complete discussions and descriptions of Figures 1A-E, respectively.

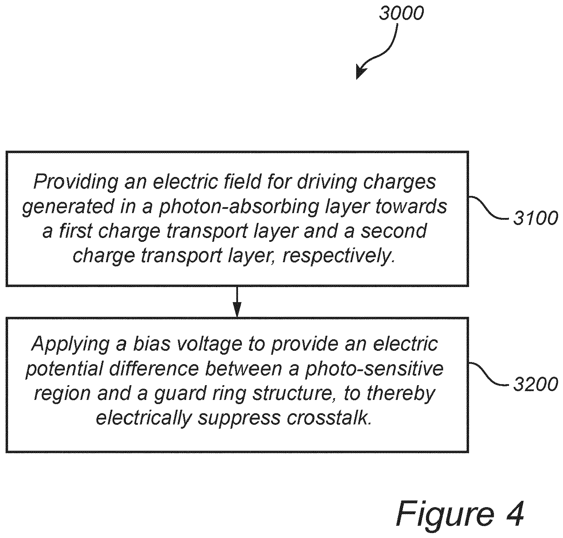

Figure 4 shows a method 3000 for operating a photo-sensitive device, e.g., according to any one or more of Figures 1A-E, 2, and 3A-E.

The method 3000 comprises providing 3100 an electric field for driving charges generated in a photon-absorbing layer towards a first node and a second node, respectively.

The method 3000 further comprises applying 3200 a bias voltage to provide an electric potential difference between a photo-sensitive region and a guard ring structure, to thereby electrically suppress crosstalk.

In accordance with the method 3000, the steps of providing 3100 an electric field and applying 3200 a bias voltage may be performed by a controlled power source.

The electric field may be provided at all operational instances before signal saturation or at least during the read-out period.

The bias voltage may be applied at all operational instances or at least during the integration period.

In the above the inventive concept has mainly been described with reference to a number of non-limiting examples. However, as is readily appreciated by a person skilled in the art, other examples than the ones disclosed above are equally possible within the scope of the inventive concept, as defined by the appended claims.

## Claims

1. A photo-sensitive device (100; 200; 300; 400; 500) comprising:
a stack (102; 202; 302; 402; 502) forming a photodiode, which stack (102; 202; 302; 402; 502) comprises a photon-absorbing layer (116; 216; 316; 416; 516), wherein the photon-absorbing layer (116; 216; 316; 416; 516) is configured to generate charges in response to incident light on the photo-sensitive device (100; 200; 300; 400; 500), defining a photo-sensitive region (104; 204; 304; 404; 504),
wherein a first electrode layer (110; 210; 310; 410; 510) and a second electrode layer (120; 220; 320; 420; 520) are arranged on opposite sides of the photon-absorbing layer (116; 216; 316; 416; 516), wherein the first electrode layer (110; 210; 310; 410; 510) and the second electrode layer (120; 220; 320; 420; 520) are configured to provide an electric field for driving charges generated in the photon-absorbing layer (116; 216; 316; 416; 516) towards a first node comprising the first electrode layer (110; 210; 310; 410; 510) and a second node comprising the second electrode layer (120; 220; 320; 420; 520), respectively,
wherein a guard ring structure (140; 240; 340; 440; 540) is arranged along a boundary of the photo-sensitive region (104; 204; 304; 404; 504), said guard ring structure (140; 240; 340; 440; 540) comprising a third electrode layer (142; 242; 342; 442; 542) being physically and electrically separated from the first electrode layer (110; 210; 310; 410; 510), and an insulator layer (144; 244; 344; 444; 544),
wherein the photo-sensitive device (100; 200; 300; 400; 500) is configured to apply a bias voltage (150; 250; 350; 450; 550) to provide an electric potential difference between the photo-sensitive region (104; 204; 304; 404; 504) and the guard ring structure (140; 240; 340; 440; 540), to thereby electrically suppress crosstalk.

2. The photo-sensitive device (100; 200; 300; 400; 500) according to claim 1, wherein each layer defines a geometric plane, and wherein the insulator layer (144; 244; 344; 444; 544) is in the same geometric plane as the first electrode layer (110; 210; 310; 410; 510) and/or the first node.

3. The photo-sensitive device (100; 200; 300; 400; 500) according to claim 1 or 2, wherein each layer defines a geometric plane, and wherein the first electrode layer (110; 210; 310; 410; 510) and the third electrode layer (142; 242; 342; 442; 542) are in the same geometric plane and separated by a recess consisting of an insulating material (145; 245; 345; 445; 545), or wherein the third electrode layer (142; 242; 342; 442; 542) is spatially juxtaposed and situated directly adjacent to the insulator layer (144; 244; 344; 444; 544) in the geometric plane defined by the first electrode layer (110; 210; 310; 410; 510).

4. The photo-sensitive device (100; 200; 300; 400; 500) according to any one of the preceding claims wherein the stack (102; 202; 302; 402; 502) further comprises a first charge transport layer (114; 214; 314; 414; 514) and a second charge transport layer (118; 218; 318; 418; 518), wherein the photon-absorbing layer (116; 216; 316; 416; 516) is arranged between the first charge transport layer (114; 214; 314; 414; 514) and the second charge transport layer (118; 218; 318; 418; 518), and wherein the first charge transport layer (114; 214; 314; 414; 514) and the second charge transport layer (118; 218; 318; 418; 518) are configured to transport charges of opposite signs to the first electrode layer (110; 210; 310; 410; 510) and the second electrode layer (120; 220; 320; 420; 520), respectively.

5. The photo-sensitive device (100; 200; 300; 400; 500) according to claim 4, wherein the guard ring structure (140; 240; 340; 440; 540) further comprises a third charge transport layer (346; 346; 546) configured to transport charges of the same sign as the first charge transport layer (114; 214; 314; 414; 514), wherein the insulator layer (144; 244; 344; 444; 544) is arranged between the third electrode layer (142; 242; 342; 442; 542) and the third charge transport layer (346; 346; 546), or wherein the third charge transport layer (346, 346, 546) is arranged between the third electrode layer (142; 242; 342; 442; 542) and the insulator layer (144; 244; 344; 444; 544).

6. The photo-sensitive device (100; 200; 300; 400; 500) according to claim 5, wherein the first charge transport layer (114; 214; 314; 414; 514) and the third charge transport layer (346; 346; 546) are one continuous charge transport layer, or wherein the first charge transport layer (114; 214; 314; 414; 514) and the third charge transport layer (346; 446; 546) are in the same plane and separated by a recess consisting of an insulating material (145; 245; 345; 445; 545).

7. The photo-sensitive device (100; 200; 300; 400; 500) according to any one of the preceding claims, wherein the photo-sensitive device (100; 200; 300; 400; 500) is configured to be connected to a power source (160), or wherein the photo-sensitive device (100; 200; 300; 400; 500) comprises a power source (160) for providing the bias voltage (150; 250; 350; 450; 550) via the guard ring structure (140; 240; 340; 440; 540).

8. The photo-sensitive device (100; 200; 300; 400; 500) according to any one of the preceding claims, wherein the photo-sensitive device (100; 200; 300; 400; 500) is configured to accumulate charges at the first node during an integration period, and wherein the first node is connected to a read-out circuit during a subsequent read-out period for reading out a signal representative of the incident light accumulated during the integration period on the photo-sensitive device (100; 200; 300; 400; 500).

9. The photo-sensitive device (100; 200; 300; 400; 500) according to any one of the preceding claims, wherein the photo-sensitive region (104; 204; 304; 404; 504) is a pixel, and wherein the electrically suppressed crosstalk is pixel crosstalk.

10. The photo-sensitive device (100; 200; 300; 400; 500) according to any one of the preceding claims, further comprising at least two different photo-sensitive regions (104; 204; 304; 404; 504).

11. The photo-sensitive device (100; 200; 300; 400; 500) according to any one of the preceding claims when dependent on claim 4, having a lower electric potential along the boundary of the photo-sensitive region relative to the photo-sensitive region (104; 204; 304; 404; 504), wherein the first charge transport layer (114; 214; 314; 414; 514) is an electron transport layer, and the second charge transport layer (118; 418; 518) is a hole transport layer.

12. An image sensor (2000) comprising an array (600; 700; 800; 900; 1000; 2200) of photo-sensitive devices according to any one of the preceding claims.

13. The image sensor (2000) according to claim 11, when dependent on claim 4, wherein the second charge transport layer (618; 718; 818; 918; 1018) and the photon-absorbing layer (616; 716; 816; 916; 1016) are continuous layers extending over a plurality of photo-sensitive devices of the array (600; 700; 800; 900; 1000; 2200).

14. The image sensor (2000) according to claim 10, wherein the first node, the photon-absorbing layer (616; 716; 816; 916; 1016) and the second node of the photo-sensitive devices are arranged on a semiconductor substrate (608; 708; 808; 908; 1008) comprising the read-out circuit for reading out the signals representative of the incident light on the photo-sensitive devices.

15. A method (3000) of operating a photo-sensitive device according to any of the preceding claims, the method (3000) comprising:
providing (3100) an electric field for driving charges generated in the photon-absorbing layer towards the first node and the second node, respectively; and
applying (3200) a bias voltage to provide an electric potential difference between the photo-sensitive region and the guard ring structure, to thereby electrically suppress crosstalk.
